# EUROPEAN PATENT APPLICATION

(11) **EP 2 012 350 A2**
(43) Date of publication of application: **07.01.2009**
(21) Application number: 08154375.3
(22) Date of filing: 11.04.2008
(51) Int. Cl.: H01L 21/3205, G02F 1/1362

(54) **Method of forming metal pattern, patterned metal structure, and thin film transistor-liquid crystal displays using the same**

(30) Priority: 25.06.2007 KR 20070062182
(71) Applicant: Samsung Electronics Co., Ltd., Suwon-si, Gyeonggi-do 442-742 (KR)
(72) Inventor: Song, Ki Yong, 449-712, Gyeonggi-do (KR); Cho, Sung Hen, 449-712, Gyeonggi-do (KR); Moon, Jun Hyuk, 449-712, Gyeonggi-do (KR); Jeong, Chang Oh, 449-712, Gyeonggi-do (KR); Ning, Hong Long, 449-712, Gyeonggi-do (KR)
(74) Representative: Zijlstra, Robert Wiebo Johan

(57) **Abstract**

Disclosed is a method of forming a metal pattern, the method comprising depositing a dielectric substrate on a supporting substrate; forming a latent mask pattern of a metal pattern on the dielectric substrate; etching the dielectric substrate exposed by the latent mask pattern; forming a seed layer on the supporting substrate by activating the supporting substrate; removing the latent mask pattern and the portion of the seed layer disposed on the latent mask pattern through a lift-off process; and plating a metal layer on the patterned seed layer.

## Description

Disclosed is a method of forming a metal pattern, a patterned metal structure, and a thin-film transistor liquid-crystal display (TFT-LCD).

As electronic devices gradually become miniaturized and increasingly integrated, a problem has arisen in the field of liquid crystal displays in that as the line width in metal patterns is decreased, the resistance of lines in the metal patterns is increased. The increase in resistance results in signal delay, thereby deteriorating the display quality of electronic devices. This problem has become an obstacle to the development of TFT-LCDs having high image quality and large area.

In a flat panel display, such as a liquid crystal display (LCD), a display material, such as a liquid crystal, is interposed between a pair of substrates and a driving system used to apply a voltage to the display material. In the display electrical wiring comprising electrically conductive materials is installed in a substrate.

For example, in the case of an active matrix driven LCD, gate electrodes and data electrodes are disposed on a substrate. The display material is interposed between the substrates in a matrix arrangement. Thin film transistors (TFTs) and pixel electrodes are disposed at the intersections of the gate electrodes and data electrodes. The gate electrodes and data electrodes can be comprised of metals, such as tantalum (Ta), aluminum (Al), molybdenum (Mo), and the like, and are formed into films using a dry film forming method such as sputtering, for example.

To provide the electrical wiring in a large display, a vacuum film forming apparatus and etching apparatus is used, specifically for film deposition that is sized to accommodate the size of the display. The vacuum apparatus results in an increase in production costs. Therefore, to lower cost, a technology for formation of electrical wiring which can form a film at low cost, without a vacuum film forming apparatus, would be advantageous.

Further, where attempts are made to increase the area and resolution of the display, there is a problem in that driving signals are delayed due to the increase in resistance and parasitic capacitance of the wiring as display size is increased. Therefore, in order to prevent the driving signals from being delayed, efforts to decrease electrical resistance have been attempted.

Accordingly, to address the above problems, disclosed herein is a method of forming a metal pattern that can simplify processes, reduce costs, and enable the fabrication of larger TFT-LCD displays while not compromising display uniformity by providing a low-resistance metal pattern.

The disclosed method uses a wet plating technology to provide a metal pattern embedded in a dielectric substrate or a metal pattern embedded in a dielectric substrate that is disposed on a supporting substrate. Because a wet plating method is used, a vacuum film forming apparatus is not used, thereby lowering cost. The disclosed method can provide a low-resistance metal pattern by selection of the thickness of the metal pattern. Moreover, because the metal pattern is embedded in the dielectric substrate, the thickness of the liquid crystal material in the display is not affected when the thickness of the metal pattern is increased, thereby improving the overall uniformity of a display panel.

Further disclosed is a patterned metal structure formed using the inventive method.

Disclosed in an exemplary embodiment is a thin-film-transistor liquid-crystal display (TFT-LCD) that includes the patterned metal structure. The disclosed metal pattern structure can prevent a decrease in the uniformity of liquid crystal over an entire panel, even where the thickness of the electrodes is increased.

In order to improve panel uniformity, disclosed in an exemplary embodiment is a method of forming a metal pattern, comprising forming a latent mask pattern of a metal pattern on a dielectric substrate; etching the dielectric substrate not protected by the latent mask pattern; forming a seed layer on the dielectric substrate by activating the substrate; removing the latent mask pattern and the portion of the seed layer disposed on the latent mask pattern through a lift-off process to provide a patterned seed layer; and plating a metal layer on the patterned seed layer to provide a metal pattern.

In another embodiment, the dielectric substrate can be formed on a supporting substrate.

In another embodiment, disclosed is a patterned metal structure embedded in a dielectric substrate.

In another embodiment, disclosed is a patterned metal structure embedded in a dielectric substrate and disposed on a supporting substrate.

In an alternative embodiment, disclosed is a thin film transistor-liquid crystal display comprising the patterned metal structure.

The above and other objects, features and advantages of the exemplary embodiments will be more clearly understood from the following detailed description taken in conjunction with the accompanying drawings, wherein the like elements are numbered alike, in which:
FIG. 1 is a schematic sectional view showing a commercially available TFT-LCD with a pattemed metal structure;
FIG. 2 is a process view showing a method of forming a metal pattern according to an exemplary embodiment;
FIG. 3 is a schematic sectional view showing a patterned metal structure according to an exemplary embodiment; and
FIG. 4 is a schematic sectional view showing a TFT-LCD according to an exemplary embodiment.

### DETAILED DESCRIPTION OF THE INVENTION

Hereinafter, exemplary embodiments will be described in detail with reference to the attached drawings.

Reference now should be made to the drawings, in which the same reference numerals are used throughout to designate the same or similar components.

The disclosed method of forming a metal pattern includes depositing a dielectric substrate on a supporting substrate; forming a latent mask pattern of a metal pattern on the dielectric substrate; etching the portion of the dielectric substrate not protected by the latent mask pattern; forming a seed layer on the supporting substrate by activating the supporting substrate; removing the latent mask pattern and portion of the seed layer disposed on the latent mask pattern through a lift-off process; and plating a metal layer on the patterned seed layer.

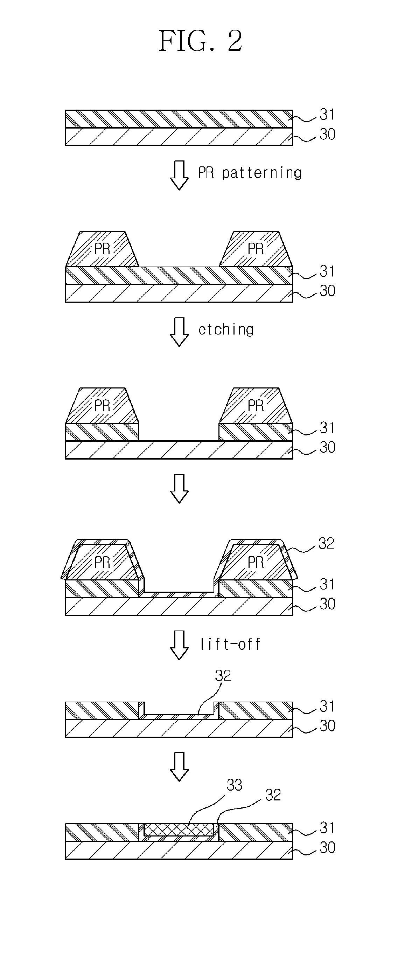

FIG. 2 is a process view showing a method of forming a metal pattern according to an exemplary embodiment. Referring to FIG. 2, which discloses a process to form a metal pattern, first, a dielectric substrate 31 is formed on a supporting substrate 30. Next, a latent mask pattern, labeled "PR" in FIG. 2 and having a configuration opposite the metal pattern, is formed on dielectric substrate 31. Subsequently, a groove is formed by etching the portion of dielectric substrate 31 left exposed by the latent mask pattern, thus exposing a portion of the supporting substrate. Then, the exposed portion of supporting substrate 30 is activated using a metal catalyst, such as a palladium catalyst, thereby disposing a seed layer 32 on the surface of supporting substrate 30 and the latent mask pattern, thereby forming a metal catalyst core. Subsequently, the latent mask pattern, and the portion of the seed layer 32 disposed on the latent mask pattern, are removed through a lift-off process, thereby leaving the seed layer in the configuration of the desired metal pattern. Finally, a metal layer 33 is formed on the patterned seed layer 32, thereby obtaining a metal pattern embedded in the dielectric substrate 31.

In the disclosed process, a metal pattern is formed by plating a metal layer in the groove formed in the dielectric substrate. In commercially available technologies, the metal pattern is disposed on the dielectric substrate and thus protrudes from the substrate.

Hereinafter, the method of forming the metal pattern, as is disclosed in the exemplary embodiments, will be described in more detail with reference to FIG 2.

### Forming a dielectric substrate

First, a dielectric substrate 31 is deposited on a supporting substrate 30. Exemplary supporting substrates include, but are not limited to, a plastic substrate or a glass substrate. Exemplary supporting substrates also include, but are not limited to a silicon wafer, indium tin oxide (ITO), mica, graphite, molybdenum sulfide, and the like, or a metal substrate such as copper, zinc, aluminum, stainless steel, magnesium, iron, nickel, gold, silver and the like, or a plastic substrate, such as a polyimide resin, a polyester resin, an acrylic resin and the like, or a combination comprising at least one of the foregoing substrates.

Commercially available methods for deposition of dielectric substrate 31 on supporting substrate 30 can be used. For example, the deposition methods can include a pulsed deposition method, a biased deposition method, a physical vapor deposition method, or a chemical vapor deposition method, and the like or a combination comprising one of the foregoing methods.

Exemplary materials for dielectric substrate 31 include dielectric materials. The material constituting the dielectric substrate 31 can include, but is not limited to, the oxides of Al, Si, Ti, Pb, In, or Sn or other metal oxides, metal nitrides, metal halogenides, organic dielectrics, and organic-inorganic composite dielectrics, and the like, or a combination comprising at least one of the foregoing materials.

### Forming a latent mask pattern

Commercially available methods can be used to form a latent mask pattern. For example, the latent mask pattern can be formed by performing a photolithography process in which a photoresist composition is disposed on the dielectric substrate 31, the photoresist selectively exposed to UV light through a mask having the metal pattern, and then developing the exposed photoresist composition. In this embodiment, the photoresist composition, exposure conditions, and the like are not particularly limited. However, the latent mask pattern is formed in direct opposition to the desired metal pattern so the desired metal pattern can be obtained by performing a lift-off process later.

### Etching of dielectric substrate

After the latent mask pattern is formed on the dielectric substrate 31, a groove is formed by etching the portion of dielectric substrate 31 left exposed and thus not protected by the latent mask pattern. When the groove is formed in the dielectric substrate, the dielectric substrate can be etched such that the supporting substrate is exposed, or the dielectric substrate can be partially etched such that the supporting substrate is not exposed. The depth of the groove etched into the dielectric substrate can be selected depending on the thickness of the desired metal pattern.

The dielectric substrate can be etched by a commercially available etching method, such as a wet etching method, a dry etching method, and the like, but the method thereof is not limited thereto.

### Forming a seed layer

The metal pattern can be formed using an electroless plating method, which is a wet plating method. In the electroless plating method, a desired film is plated using the difference in the ionization tendency between a reductant and an oxidant in a solution after activating a substrate such as the dielectric substrate or supporting substrate. The electroless plating method is advantageous in that, since it can be simultaneously performed over the entire substrate without using external power, production costs are low and processes are simple, and thus productivity can be high.

Electroless plating proceeds through autocatalytic nucleation and growth, and employs a seed to start the reaction. Since most metals in themselves do not function as a catalyst, a metal core is formed to enable the growth of metal by performing activation treatment before the electroless plating.

After a groove is formed by etching the dielectric substrate, activation treatment is performed to form an active layer of metal cores for plating. The activation treatment is performed by immersing a substrate into a colloidal catalyst plating solution containing a metal, such as palladium, for activation treatment. The activation treatment can be performed at room temperature. When this activation treatment is performed, a metal core, acting as a catalyst surface, is formed on the exposed surfaces, specifically the dielectric substrate and/or the supporting substrate if exposed, thereby enabling electroless plating on the dielectric substrate and/or the supporting substrate.

The metal catalyst used as the metal for activation treatment can include, but is not limited to, gold, silver, copper, nickel, tin, iron, palladium, and platinum, and the like, or a combination comprising at least one of the foregoing metals. In an exemplary embodiment, a catalyst solution comprising the palladium metal catalyst includes zinc chloride. When the activation treatment is completed, the substrate can be washed in deionized water in order to remove any remaining catalyst plating solution.

When this activation treatment is performed, a metal core is formed on the surface of the dielectric substrate and/or supporting substrate, and this metal core serves as a catalyst for accelerating the growth of metal crystals in a subsequent plating process.

### Removing the latent mask pattern through a lift-off process

Referring to FIG. 2, after a seed layer 32 is formed, and before a metal layer 33 is formed, a desired metal pattern is formed by first performing a lift-off process, and then the metal layer 33 is selectively plated only where seed layer 32 is present, thereby providing the desired metal pattern. Specifically, the lift-off process is a process of removing the latent mask pattern using a solution or organic solvent (such as acetone, for example), thereby dissolving the latent mask pattern, and, in the process, the seed layer formed on the latent mask pattern is also removed. Therefore, the latent mask pattern, formed with a configuration in opposition to the desired metal pattern, is removed, leaving the seed layer in the configuration of the desired metal pattern.

### Forming of metal layer

The latent mask pattern, formed in opposition to the desired metal pattern, is removed through the lift-off process, leaving seed layer 32 with a configuration of the desired metal pattern. Metal layer 33 is selectively plated only where seed layer 32 is present, thereby forming the desired metal pattern. This plating treatment can be performed using a wet electroless plating method or a wet electrolytic plating method.

The metal plated in the plating treatment can be Ni, Cu, Ag, Au, and the like, or a combination of at least one of the foregoing metals, or alloys thereof. Specifically, to obtain a highly conductive metal pattern, a solution comprising a copper or silver compound, or a combination of the foregoing compounds can be used.

Electroless plating or electrolytic plating can be performed using commercially available methods. Disclosed in an exemplary embodiment is electroless copper plating. In an embodiment where electroless copper plating is used, the plating of the metal layer is performed by immersing the dielectric substrate and/or supporting substrate into an electroless copper plating solution that comprises copper salts, a copper complexing agent (to suppress a liquid phase reaction), a reductant (to reduce copper ions), a pH adjuster (to maintain the pH at a pH suitable for oxidization of the reductant), and, optionally, a pH buffer and a modifier.

The copper salts can include, but are not limited to, copper chlorides, copper nitrates, copper sulfates, and copper cyanides, and the like, or a combination of at least one of the foregoing salts, specifically the salt can include copper sulfates.

The reductant can include NaBH₄, KBH₄, NaH₂PO₂, hydrazine, formalin, and a polysaccharide such as glucose, and the like, or a combination of at least one of the foregoing reductants, and specifically can include formalin and a polysaccharide such as glucose.

Specifically, the complexing agent can include a chelator, such as an ammonia solution, acetic acid, guanylic acid, tartaric acid salt, ethylenediaminetetracetic acid (EDTA), Rochelle salt, potassium sodium tartrate, and the like, or a combination of at least one of the foregoing chelators. Specifically, the complexing agent can include an organic amine compound, and more specifically can include a chelator such as EDTA. The pH adjuster can include an acid compound and an alkali compound. The pH buffer can include an organic acid and weakly acidic inorganic compounds. The modifier, which is a compound for improving the coating and flattening characteristics of a plating layer, can include surfactants and adsorptive materials for adsorbing materials that prevent the growth of crystals.

In an embodiment, where electrolytic plating is used to grow copper crystals, the plating of the metal layer is performed by immersing the dielectric substrate and/or supporting substrate into a plating solution that comprises copper salts, a complexing agent, a pH adjuster, a pH buffer and a modifier.

The disclosed method of forming a metal pattern can further include annealing a metal pattern in order to improve the electrical properties, remove water from the metal layer, and improve the adhesion of the metal pattern. The annealing of the metal pattern can be performed at a temperature of 40 to 400°C, specifically 60 to 360°C, more specifically 100 to 300°C, for 15 to 120 minutes, specifically 30 to 100 minutes, more specifically 45 to 75 minutes, in an inert atmosphere of nitrogen, argon, and the like, or in a vacuum.

Further, after the metal layer is selectively formed, a protective layer can be formed on the metal layer using an electroless plating method in order to protect the metal pattern. The protective layer can include nickel and a nickel alloy.

In the method of forming a metal pattern, as is disclosed in exemplary embodiment, the metal pattern is formed using a plating method, which is a wet film forming method, the process costs of which are much lower than those of a vacuum deposition method. Thus total production costs can be decreased because the number of etching processes is decreased. Further, in the wet film forming method, since the film is formed in an aqueous solution, the energy consumption is lower than that of a dry film forming method because the film is formed at a temperature of 100°C or less. Thus a large metal pattern can be formed at lower cost than when a dry film forming method is used because the need for a vacuum apparatus able to accommodate the metal pattern is decreased Moreover, the resulting metal film can be uniformly formed over the entire substrate.

In an alternative embodiment, the dielectric substrate itself can serve as the supporting substrate. Accordingly, disclosed is a method of forming a metal pattern that includes forming a latent mask pattern of a metal pattern on a dielectric substrate; etching the portion of the dielectric substrate left exposed by the latent mask pattern; forming a seed layer on the dielectric substrate by activating the dielectric substrate; removing the latent mask pattern and upper portion thereof through a lift-off process; and plating a metal layer on the patterned seed layer.

The dielectric substrate can be comprised of any dielectric material. The dielectric substrate can include, but is not limited to metal oxides, specifically oxides of Al, Si, Ti, In, and Sn, metal nitrides, metal halogenides, organic dielectrics, and organic-inorganic composite dielectrics, and the like, or a combination of at least one of the foregoing dielectrics. In the etching of the dielectric substrate, the groove in the dielectric substrate can be formed using the same method as the method of etching the dielectric substrate and the depth of the groove can be selected depending on the desired thickness of the metal pattern. Other processes are the same as in the method of forming a metal pattern including the dielectric substrate.

In an alternative embodiment, the method of forming a metal pattern can further include forming an auxiliary metal film before or after the lift-off process is performed in order to improve the adhesion of the metal layer. To form an auxiliary metal film, an auxiliary metal film is plated on a seed layer. The auxiliary metal film can include, but is not limited to, nickel, tin, cobalt, palladium, platinum, gold, silver, and zinc, and the like, or a combination of at least one of the foregoing metals.

When the auxiliary metal film is formed before the lift-off process is performed, the auxiliary metal film, other than a portion on which a metal layer will be formed, is removed together with a seed layer in the lift-off process. When the auxiliary metal film is formed after the lift-off process is performed, the auxiliary metal film is selectively formed on the seed layer.

The process of plating the auxiliary metal film can be performed using a commercially available plating method. For example, to form a nickel film, a nickel plating solution including nickel chlorides can be used. After plating the auxiliary metal film, an annealing process can be included to further improve adhesion of the auxiliary metal film.

The auxiliary metal film can have a thickness of 5 to 100 nm, specifically 10 to 90 nm, more specifically 25 to 75 nm. The thickness of the auxiliary metal film can be selected to provide optimal uniformity and conductivity.

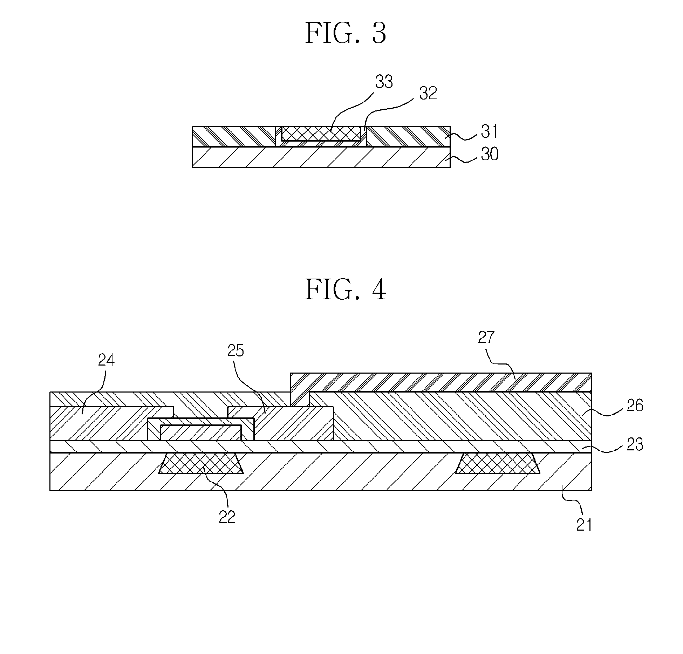

Disclosed in an embodiment is a patterned metal structure that has high production processability and can provide low resistance by selection of the thickness of the electrodes. FIG. 3 is a schematic sectional view showing a patterned metal structure according to an exemplary embodiment. Referring to FIG. 3, the patterned metal structure is embedded in a dielectric substrate or in a dielectric substrate disposed on a supporting substrate. That is, the patterned metal structure includes a seed layer 32 and a metal layer 33, the seed layer including a metal catalyst, where the seed layer and metal layer are disposed in a groove formed in the dielectric substrate 31 and disposed on the supporting substrate 30.

In the patterned metal structure, the seed layer 32 can include, but is not limited to, a metal selected from the group consisting of gold, silver, copper, nickel, tin, iron, platinum, and palladium and the like, or a combination of at least one of the foregoing metals.

In the patterned metal structure, the metal layer 33 can comprise a metal selected from the group consisting of Ni, Cu, Ag, Au, and the like, or a combination of at least one of the foregoing metals, and alloys thereof.

The patterned metal structure can further include an auxiliary metal film formed between the seed layer 32 and the metal layer 33, and can further include a protective layer, comprised of nickel or a nickel alloy, the protective layer formed on the metal layer 33 in order to protect the metal layer 33. That is, the patterned metal structure can have a multi-layered structure.

Disclosed in an alternative embodiment is a thin-film transistor liquid-crystal display (TFT-LCD) comprised of the embedded patterned metal structure. The disclosed patterned metal structure can be used in various displays, such as liquid crystal displays (LCDs), field emission displays (FEDs), electrophoresis displays (EPDs), plasma display panels (PDPs), electroluminescent displays (ELDs) and electrochromic displays (ECDs); flat panel image sensors using an active matrix substrate; printed circuit boards using a ceramic substrate; and the like.

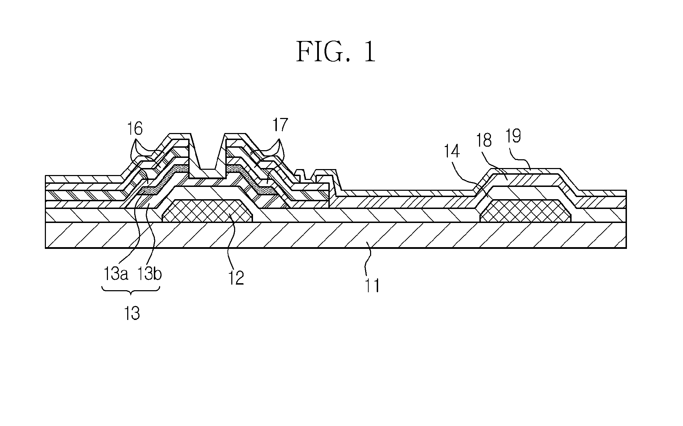

In particular, when the patterned metal structure is used in liquid crystal displays (LCDs), it is advantageous in that the production costs of the LCD displays can be decreased and larger LCD displays can be manufactured. As shown in FIG. 1, in the case of a commercially available TFT-LCD, there is a problem in that, when the thickness of electrodes is increased in order to decrease resistance, the height of the liquid crystal is decreased at the upper portion of electrode. Moreover, the difference in liquid crystal distribution between the regions occupied by the thin film transistor and the regions not occupied by the thin film transistor across the entire panel is increased, thereby decreasing the uniformity of the liquid crystals in the entire panel.

Commercial liquid crystal display devices can include gate lines formed in a transverse direction, data lines formed in a longitudinal direction intersecting the gate lines, and thin film transistors formed at the intersections of the gate lines and the data lines. Pixel electrodes in electrical communication with the thin film transistors through drain contact holes are formed in pixel regions, which are defined as regions where the gate lines and the data lines intersect. The thin film transistor includes gate electrodes branching from the gate lines, a semiconductor layer covering the gate electrodes, source electrodes that overlap both ends of the semiconductor layer at regular intervals and branch from the data lines, and drain electrodes that are spaced apart from the source electrodes and connect the pixel electrodes with the thin film transistor. FIG. 1 is a schematic sectional view of a commercially available liquid crystal display including a patterned metal structure. As shown in FIG. 1, the commercially available liquid crystal includes a transparent substrate 11; gate electrodes 12 formed on the substrate 11; a gate insulating film 14 formed on the gate electrodes 12; and a semiconductor layer 13 formed on the portion of the gate insulating film 14 covered by the gate electrodes 12. Source electrodes 16 and drain electrodes 17, spaced apart from each other at intervals, are formed on the semiconductor layer 13, and channels are formed in the gaps between the source electrodes 16 and the drain electrodes 17. The semiconductor layer 13 comprises an active layer 13a formed of pure amorphous silicon (a-Si), and an ohmic contact layer 13b, formed of n-doped amorphous silicon (n+ a-Si), disposed on active layer 13a. A protective layer 18, having drain contact holes for partially exposing the drain electrodes 17, is formed in the upper portion of the thin film transistor, and pixel electrodes 19 in electrical communication with the drain electrodes 17 through the drain contact holes are formed in pixel regions located in the upper portion of the protective layer 18.

Referring to FIG. 4, the disclosed thin film transistor-liquid crystal display (TFT-LCD) according to an exemplary embodiment, unlike the commercially available LCDs, can include a substrate 21; gate electrodes 22 formed in the substrate 21; a gate insulation film 23 formed on the entire surface of the substrate 21 and gate electrodes 22; a semiconductor layer formed on the gate insulation film 23; source and drain electrodes spaced apart from each other at selected intervals; and channels formed between the source and drain electrodes. The TFT-LCD can further include a thin film transistor; a protective layer 26 formed on the thin film transistor, the protective layer having a drain contact hole partially exposing the drain electrode 25; and a pixel electrode 27 formed in a pixel region located on the protective layer 26, the pixel electrode 27 in electrical communication with the drain electrode 25 through the drain contact hole. The disclosed TFT-LCD is not limited to the configuration of the exemplary embodiments, and can be variously changed and modified by those skilled in the art.

In the disclosed TFT-LCD, since the gate electrodes 22 and data electrodes are embedded in the substrate 21, the entire panel has a flat structure, thereby resolving the problem of the decrease in the uniformity of the entire panel even where the thickness of the electrodes is increased in order to overcome the delay of driving signals in large TFT-LCDs due increased wiring resistance and parasitic capacitance.

Hereinafter, exemplary embodiments will be described in detail with reference to Examples. These Examples are set forth to illustrate exemplary embodiments, but should not be construed to limit the embodiments.

### Example 1

A silicon nitride dielectric substrate was formed by depositing a silicon nitride film having a thickness of 400 nanometers (nm) on an insulated glass substrate using chemical vapor deposition. Subsequently, a photoresist (AZ-1512, manufactured by Clariant International Ltd.) was applied on the silicon nitride dielectric substrate using a spin-coating method at a rotation speed of 1200 rpm, at room temperature, for 30 seconds, and at a viscosity of 20 centipoise. Then, the substrate coated with the photoresist was patterned by exposing the applied photoresist for 7 seconds using ultraviolet-exposure (broad band UV with power of 9 milli-Joules per square centimeter), available from Oriel Inc., as a light source through a photomask, and then developing the exposed photoresist. The exposed portion of the photoresist was removed from the pattemed substrate using a hydrogen fluoride solution having a concentration of 0.25 weight percent (wt%) for 200 seconds.

Subsequently, a groove having a width of 10 micrometers and a thickness of 400 nm was formed by etching the exposed portion of the silicon nitride dielectric substrate. Then, the substrate, in which the groove was formed, was immersed into a colloidal palladium catalyst solution. The colloidal palladium catalyst solution is a catalyst for copper plating. The substrate was then washed in water, treated using an acceleration solution, the acceleration solution comprised mainly of 1 % hydrochloric acid, for 5 minutes, washed in water, and then dried at 120°C for 50 minutes.

Subsequently, the photoresist remaining on the substrate was removed using acetone, which is a photoresist stripper, in a lift-off process. Finally, a copper pattern, having a thickness of 350 nm, was obtained by immersing the patterned substrate into an electroless copper plating solution comprising 3.5 g of copper sulfate, 8.5 g of tartaric acid, 22 milliliters of formalin (37 wt%), 1 g of thio-urea and 40 g of ammonia at a temperature of 60 °C for 5 minutes.

### Test Example 1 : Specific resistance of a metal pattern.

The specific resistance of the metal pattern obtained in Example 1 was measured using measuring equipment of JANDEL Corp. The metal pattern was determined to have a specific resistance of 2.7 micro-ohms per centimeter (µΩ/cm).

When the disclosed method of forming a metal pattern or the disclosed patterned metal structure is used, processes can be simplified and production costs reduced because wet plating methods can be used, thereby avoiding the use of a vacuum film forming apparatus. Moreover, the uniformity of a TFT-LCD display can be improved because a low-resistance metal pattern can be obtained by selecting the thickness of the metal pattern because the disclosed metal pattern is embedded in the dielectric substrate, or a dielectric substrate disposed on a supporting substrate.

As is disclosed in an exemplary embodiment, a method of forming a metal pattern is disclosed that provides a metal pattern in a short period of time through a wet film forming process, without performing a sputtering process, without use of high-temperatures, and without the use of high vacuum conditions, thus reducing installation expenses and production costs. Moreover, since the patterned metal structure is embedded in a dielectric substrate, and optionally disposed on a supporting substrate, a low-resistance metal pattern can be realized by increasing the thickness of electrodes while avoiding any decrease in overall uniformity of a panel in a thin-film transistor liquid-crystal display using the metal pattern. As a result product reliability and price competitiveness are improved.

As described above, although the preferred embodiments of exemplary embodiments have been disclosed for illustrative purposes, those skilled in the art will appreciate that various modifications, additions and substitutions are possible, without departing from the scope of the invention as disclosed in the accompanying claims.

This written description uses examples to disclose the invention, including the best mode, and also to enable any person skilled in the art to practice the invention, including making and using any devices or systems and performing any incorporated methods. The patentable scope of the invention is defined by the claims, and can include other examples that occur to those skilled in the art. Such other examples are intended to be within the scope of the claims if they have elements that do not differ from the literal language of the claims, or if they include equivalent elements with insubstantial differences from the literal language of the claims.

While the invention has been described with reference to exemplary embodiments, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

The terms "first," "second," and the like, "primary," "secondary," and the like, as used herein do not denote any order, quantity, or importance, but rather are used to distinguish one element from another.

The terms "a" and "an" do not denote a limitation of quantity, but rather denote the presence of at least one of the referenced item.

"Optional" or "optionally" means that the subsequently described event or circumstance may or may not occur, and that the description includes instances where the event occurs and instances where it does not.

Compounds are described using standard nomenclature. Unless defined otherwise, technical and scientific terms used herein have the same meaning as is commonly understood by one of skill in the art to which this invention belongs.

The modifier "about" used in connection with a quantity is inclusive of the stated value and has the meaning dictated by the context (e.g., includes the degree of error associated with measurement of the particular quantity).

The terms "front", "back", "bottom", and/or "top" are used herein, unless otherwise noted, merely for convenience of description, and are not limited to any one position or spatial orientation.

The endpoints of all ranges directed to the same component or property are inclusive of the endpoint and independently combinable.

The suffix "(s)" as used herein is intended to include both the singular and the plural of the term that it modifies, thereby including one or more of that term (e.g., the colorant(s) includes one or more colorants).

As used herein, "combination" is inclusive of blends, mixtures, alloys, reaction products, and the like.

Reference throughout the specification to "one embodiment", "another embodiment", "an embodiment", and so forth, means that a particular element (e.g., feature, structure, and/or characteristic) described in connection with the embodiment is included in at least one embodiment described herein, and may or may not be present in other embodiments. In addition, it is to be understood that the described elements may be combined in any suitable manner in the various embodiments.

## Claims

1. A method of forming a metal pattern, the method comprising:
forming a latent mask pattern of a metal pattern on a dielectric substrate;
etching the dielectric substrate not protected by the latent mask pattern;
forming a seed layer on the dielectric substrate by activating the dielectric substrate;
removing the latent mask pattern and the portion of the seed layer disposed on the latent mask pattern through a lift-off process to provide a patterned seed layer; and
plating a metal layer on the patterned seed layer to provide a metal pattern.

2. The method of claim 1, further comprising forming the dielectric substrate on a supporting substrate.

3. The method according to claim 2, wherein the supporting substrate comprises a material selected from the group consisting of silicon, glass, indium tin oxide, mica, graphite, molybdenum sulfide, copper, zinc, aluminum, stainless steel, magnesium, iron, nickel, gold, silver, a polyimide resin, a polyester resin, a polycarbonate resin, and an acrylic resin, or a combination of at least one of the foregoing materials.

4. The method according to any of claims 1-3, wherein the dielectric substrate comprises a material selected from the group consisting of metal oxides including Aluminum oxide, Silicon oxide, Titanium oxide, Indium oxide, Tin Oxide and Lead Oxide, metal nitrides, metal halogenides, organic dielectrics, and organic-inorganic composite dielectrics, or a combination of at least one of the foregoing materials.

5. The method according to claim 2 or 3, wherein a groove is etched in the dielectric substrate such that the supporting substrate is exposed, or the dielectric substrate is partially etched, such that the supporting substrate is not exposed.

6. The method according to any of claims 1-5, wherein, in the forming of the seed layer, the dielectric substrate is activated using a compound comprising a metal selected from the group consisting of gold, silver, copper, nickel, tin, iron, platinum, and palladium, or a combination of at least one of the foregoing metals.

7. The method according to any of claims 1-6, wherein in the plating of the metal layer the plated metal is selected from the group consisting of Ni, Cu, Ag, Au, and an alloy thereof or a combination of at least one of the foregoing metals.

8. The method according to any of claims 1-6, wherein the plating of the metal layer is performed by immersing the dielectric substrate into an electroless copper plating solution, the solution comprising copper salts, a complexing agent, a reductant, and a pH adjuster, or a combination of at least one of the foregoing compounds.

9. The method according to any of claims 1-8, further comprising forming an auxiliary metal film before or after the removing of the latent mask pattern through the lift-off process.

10. The method according to claim 9, wherein the auxiliary metal film comprises one or more metals selected from the group consisting of nickel, tin, cobalt, palladium, platinum, gold, silver, and zinc.

11. A pattemed metal structure embedded in a dielectric substrate, wherein the patterned metal structure comprises a seed layer and a metal layer, the seed layer comprising a metal catalyst, wherein the seed layer and the metal layer are disposed in a groove formed in the dielectric substrate.

12. The patterned metal structure according to claim 11, wherein the metal layer comprises a conductive material selected from the group consisting of Ni, Cu, Ag, Au, and an alloy thereof, or a combination of at least one of the foregoing materials.

13. The patterned metal structure according to claim 11 or 12, wherein the seed layer comprises a material selected from the group consisting of gold, silver, copper, nickel, tin, iron, platinum, and palladium, or a combination of at least one of the foregoing materials.

14. The pattemed metal structure according to any of claims 11-13, wherein the patterned metal structure further comprises an auxiliary metal film formed between the seed layer and the metal layer, wherein the auxiliary metal film comprises one or more metals selected from the group consisting of nickel, tin, cobalt, palladium, platinum, gold, silver, and zinc, or a combination of at least one of the foregoing metals.

15. A thin film transistor-liquid crystal display, the display comprising the patterned metal structure according to any of claims 11-14.
